# EUROPÄISCHE PATENTSCHRIFT

(11) **EP 2 559 328 B1**
(45) Veröffentlichungstag und Bekanntmachung des Hinweises auf die Patenterteilung: **25.12.2013**
(21) Anmeldenummer: 11708282.6
(22) Anmeldetag: 15.03.2011
(51) Int. Cl.: F24F 1/58, F24F 13/20, H05K 7/20

(54) **ABDECKUNG FÜR EINE KLIMATISIERUNGSEINRICHTUNG**
COVER FOR AN AIR CONDITIONING DEVICE
CACHE POUR DISPOSITIF DE CLIMATISATION

(30) Priorität: 16.04.2010 DE 102010016488
(43) Veröffentlichungstag der Anmeldung: 20.02.2013
(73) Patentinhaber: RITTAL GmbH & Co. KG, 35745 Herborn (DE)
(72) Erfinder: HARTMANN, Reiner, 35435 Wettenberg (DE)
(74) Vertreter: Tönhardt, Marion
(86) Internationale Anmeldenummer: PCT/EP2011/053896
(87) Internationale Veröffentlichungsnummer: WO 2011/128168

(56) Entgegenhaltungen:
- EP-A2- 0 979 978
- EP-A2- 1 031 799
- JP-A- 5 296 487
- JP-A- 10 009 610
- JP-A- 58 102 034

## Beschreibung

Die Erfindung betrifft eine Abdeckung für mindestens eine an einem Verkleidungselement insbesondere eines Schaltschrankes angeordnete Klimatisierungseinrichtung, mit einem Abdeckungsgehäuse, das eine Frontwand und daran angeschlossene Seitenteile aufweist, wobei die Seitenteile die Frontwand beabstandet zu dem Verkleidungselement halten und an dem Verkleidungselement mindestens eine Halterung für das Abdeckungsgehäuse angebracht ist, und wobei die Halterung vertikale Hakenelemente aufweist, in die das Abdeckungsgehäuse mit Hakenaufnahmen in Schwerkraftrichtung eingehängt werden kann.

Schaltschränke werden häufig in Umgebungen betrieben, in der sie Staub und Feuchtigkeit ausgesetzt sind. Um die in den Schaltschränken eingebauten elektronischen Einbauten hiervor zu schützen, sind die Schaltschränke gegenüber der Umgebung abgedichtet. Die von den elektronischen Einbauten erzeugte Wärme lässt sich durch alleinige Konvektion nicht mehr ausreichend abführen. Aus diesem Grund wird aus einem Verkleidungselement, beispielsweise einer Seitenwand oder einem Deckelteil, der den Schaltschrank abdeckt, ein Durchbruch ausgespart. In diesen Durchbruch wird eine Klimatisierungseinrichtung eingesetzt. Über diese kann Luft aus der Umgebung zur Kühlung angesaugt oder an diese abgegeben werden. Als Klimatisierungseinrichtungen sind häufig Lüfter, Ansaugkanäle oder dgl. verwendet. Häufig ist auch alleine der Durchbruch als Klimatisierungseinrichtung ausreichend für eine erhöhte Konvektion.

Um zu verhindern, dass durch die Klimatisierungseinrichtung Staub in den Schaltschrank gelangt, ist der Durchbruch mit einer Filtermatte abgedeckt.

Um Feuchtigkeit, beispielsweise Regen- oder Spritzwasser abzuhalten, ist beispielsweise aus der DE 43 44 659 C1 bekannt, eine Abdeckung zu verwenden. Die Abdeckung besteht aus einem geschlossenen, lediglich nach unten und zur vertikalen Seitenwand des Schaltschrankes hin offenem Abdeckungsgehäuse. Zur Befestigung des Abdeckungsgehäuses an der Seitenwand sind Befestigungsschrauben verwendet. Diese werden durch Befestigungsaufnahmen des Lüfters, der in den Durchbruch der Seitenwand eingesetzt ist, eingeführt. An der an der Seitenwand anliegenden Rückwand des Abdeckungsgehäuses sind Bohrungen vorgesehen, durch die die Schraubenbolzen der Befestigungsschrauben ragen. Auf die Schraubenbolzen sind Muttern aufgedreht, so dass der Lüfter und das Abdeckungsgehäuse mit der Seitenwand verspannt sind. Diese Montage ist sehr aufwendig, da zunächst von der Innenseite des Schaltschrankes die Befestigungsschrauben und der Lüfter von einer Person gehalten werden müssen. Eine zweite Person führt nun durch das nach unten offene Abdeckungsgehäuse von der Außenseite des Schaltschrankes her die Muttern zu den Schraubenbolzen und kontert diese.

Eine Abdeckung, die gegenüber der Abdeckung gemäß der DE 43 44 659 C1 einfacher zu montieren ist, ist aus der DE 196 41 553 C2 bekannt. Die Halterung gemäß der DE 196 41 553 C2 besitzt Führungen, an denen die Abdeckung anhängt werden kann. Damit ist die Abdeckung direkt mit dem stabilen Verkleidungselement verbunden. Diese Maßnahme stellt sicher, dass auch bei einer Gewalteinwirkung auf die Abdeckung die darunter liegenden Einheiten nicht leicht beschädigt werden können. Die Halterung ist weiterhin mit den vertikal verlaufenden Führungen ausgestattet, auf die die Abdeckung mit Führungsaufnahmen aufschiebbar bar ist. Die Führungen sind dabei beabstandet von dem Verkleidungselement gehalten.

Mit den Führungen kann das Abdeckungsgehäuse an dem Verkleidungselement festgemacht werden. Hierzu muss das Abdeckungsgehäuse mit seinen Führungsaufnahmen auf die Führungen aufgesteckt werden. Dabei ist ein erheblicher Platzbedarf oberhalb der Führungen notwendig, der durch die Länge des Abdeckungsgehäuses bestimmt wird. Die Demontage der bekannten Abdeckung ist entsprechend aufwendig.

Die EP 0 979 978 A2 offenbart eine transportable Klimaanlage, deren Gehäuse von einer Abdeckung verschlossen wird, in der Hakenelemente vorgesehen sind, die in entsprechende Öffnungen des vorderen Teils des Gehäuseabschnitts einrasten.

Die JP 10-009610 A befasst sich mit einem Klimatisierungsgerät, dessen Gehäuse an an einer Wand angebrachten Haken aufgehängt ist.

Die JP 5-296487 A zeigt ein Gehäuse eines Klimagerätes, das mittels eines übergreifenden Abschnittes über eine nach oben aufragende Kante einer Halterung gehängt ist.

Die JP 58-102034 zeigt ein Klimagerät, das in ein Fenster einzubauen ist. Dazu wird es auf Haken gehängt, die an einem Installationsrahmen vorgesehen sind.

Eine Abdeckung der eingangs genannten Gattung ist aus der EP 1 031 799 A2 bekannt. Die dort beschriebene Abdeckung weist im Bereich ihrer Seitenkanten Hakenelemente auf, die mit Hakenaufnahmen, die in Seitenteilen eines Gehäuses angebracht sind, ausgerichtet und in diese eingehängt werden, wobei eine Schaumbanddichtung zusammengedrückt wird, die das Gehäuseinnere vor Verunreinigungen schützen soll. Zwar ist angesprochen, dass die Wirkung der Schwerkraft ausreicht, um die Abdeckung am Gehäuse zu halten, für die Dichtigkeit ist dies jedoch nicht ausreichend, denn die Dichtung muss weiter durch Verriegelungsschrauben 311 komprimiert werden, damit der gewünschte Zweck erfüllt wird.

Es ist nun Aufgabe der Erfindung, eine gegenüber der gattungsgemäßen Abdeckung besonders einfach aufgebaute Abdeckung anzugeben, die bei geringem Platzbedarf und guter Handhabbarkeit bei der Montage und Demontage eine besonders gute Abdichtung ermöglicht. Die Abdeckung soll dabei die abgedeckte Klimatisierungseinrichtung wirkungsvoll gegen Spritzwasser und insbesondere auch gegen starke, gerichtete Wasserstrahlen sichern können, also eine so genannte Strahlwasserhaube bilden.

Diese Aufgabe der Erfindung wird durch eine Abdeckung gemäß den Merkmalen des Patentanspruchs 1 gelöst. Vorteilhafte Weiterbildungen sind in den Unteransprüchen beschrieben.

Erfindungsgemäß ist vorgesehen, dass die Halterung für das Abdeckungsgehäuse direkt am Verkleidungselement angebracht ist. Weiter sind die an dein Abdeckungsgehäuse vorgesehenen Hakenaufnahmen in Aufnahmeprofilen ausgebildet, die an den zugeordneten Seitenteilen angeschlossen sind und sich entlang dieser Seitenteile des Abdeckungsgehäuses erstrecken. Die Aufnahmeprofile weisen jeweils zumindest einen quer zur Vorstehrichtung der Haken-elemente angeordneten, die Hakenaufnahmen tragenden Profilabschnitt auf. Die Aufnahme-profile gewährleisten eine stabile Lagerung des Abdeckungsgehäuses. Um eine besonders stabile Befestigungsmöglichkeit für die Aufnahmeprofile zu schaffen, weisen diese jeweils einen Anlagebereich auf, der an den die Hakenaufnahmen tragenden Profilabschnitt angrenzt und parallel zu dem zugeordneten Seitenteil des Abdeckungsgehäuses abgekantet ist. Der Anlagebereich ist an der Innenseite des zugeordneten Seitenteils angeschlossen, insbesondere geklebt oder geschweißt oder gelötet.

Um ein Positionieren der Hakenelemente in den Hakenaufnahmen bzw. ein Einfädeln der Hakenelemente in die Hakenaufnahmen zu erleichtern, ist der die Hakenaufnahmen tragende Profilabschnitt an seinem freien Ende in einem Winkel in Richtung des Verkleidungselements zur Bildung einer Einfädelhilfe für die Hakenelemente abgekantet.

Um die Hakenaufnahmen des Abdeckungsgehäuses mit den Hakenelementen außer Eingriff zu bringen, muss das Abdeckungsgehäuses nur um die vertikale Hakenlänge angehoben werden. Derselbe geringe Platzbedarf nach oben wird für die Montage bzw. das Einhängen der Hakenaufnahmen in die Hakenelemente benötigt. Eine derartige Demontage bzw. Montage an einem Verkleidungselement, beispielsweise einer Seitenwand, einer Tür oder einem Deckelteil eines Schaltschranks, ist gut handhabbar und der Platzbedarf insgesamt gering.

In einfacher Wirkungsumkehr kann auch das Abdeckungsgehäuse vertikale Hakenelemente aufweisen, die in Hakenaufnahmen der Halterung in Schwerkraftrichtung eingehängt werden können.

Gemäß einer Ausführungsform kann die Halterung zumindest zwei zueinander beabstandete, von dem Verkleidungselement in Richtung des Abdeckungsgehäuses vorstehende Schenkel aufweisen. Dabei weist jeder Schenkel mindestens ein vertikales, von den Schenkeln in Richtung des Abdeckungsgehäuses vorstehendes Hakenelement auf. Durch die Beabstandung der Schenkel bzw. der daran angeordneten Hakenelemente wird eine besonders stabile Befestigungsmöglichkeit für das Abdeckungsgehäuse geschaffen.

Um die durch die Abdeckung an der abzudeckenden Klimatisierungseinrichtung richtig zu positionieren, kann zwischen den beiden Schenkeln ein Durchbruch in dem Verkleidungselement ausgebildet sein, in welchem die Klimatisierungseinrichtung eingesteckt und gesichert werden kann. Hierfür können Schnapp- oder Rastelemente oder Schraubverbindungen zum Einsatz kommen.

Gemäß einer bevorzugten Ausführungsform kann die Halterung einen U-förmigen Träger mit zwei Schenkeln aufweisen, die durch einen Verbindungsabschnitt miteinander verbunden sind. Ein derart ausgebildeter Halter ist besonders stabil und durch seine einstückige Ausbildung bei der Montage besonders einfach zu handhaben. Zudem definiert der Verbindungsabschnitt den Abstand zwischen den beiden Schenkeln.

Zur Positionierung an der abzudeckenden Klimatisierungseinrichtung kann im Verbindungsabschnitt zwischen den beiden Schenkeln ein Durchbruch ausgebildet sein, der mit dem Durchbruch in dem Verkleidungselement im Wesentlichen fluchtet und in welchem die Klimatisierungseinrichtung anordnet werden kann. Der Verbindungsabschnitt kann dabei die Klimatisierungseinrichtung wie ein Rahmen umgeben. Hierdurch wird eine vordefinierte Positionierung der Halterung und somit der Abdeckung sichergestellt.

Die Schenkel können als flache Formteile ausgebildet sein, wobei die Hakenelemente einstückig mit den Schenkeln als Verlängerung derselben ausgebildet sind. Derartige flache Formteile lassen sich einfach aus Metall oder Kunststoff herstellen. Die einstückige Ausbildung von Schenkel und Hakenelementen ist besonders stabil.

Die Hakenaufnahmen können als vertikale Aufnahmeschlitze ausgebildet sein, in welche die vertikalen, schmalen Hakenelemente in Schwerkraftrichtung eingehängt werden können. Weiterhin können die Aufnahmeprofile einen an den Anlagebereich angrenzenden, L-förmig abgekanteten Profilabschnitt aufweisen, der eine in Richtung des Verkleidungselements offene, sich entlang der Seitenteile des Abdeckungsgehäuses erstreckende vertikale Dichtungsaufnahme bildet. In die vertikale Dichtungsaufnahme lässt sich ein in Richtung des Verkleidungselements zumindest teilweise hervorstehendes Dichtungselement einlegen. Wenn das Abdeckungsgehäuse mit den Hakenaufnahmen in die Hakenelemente eingehängt wird, kommt der überstehende Teil des Dichtungselements mit dem Verkleidungselement in Kontakt. Wenn die Hakenaufnahmen vollständig in den Hakenelemente eingehängt sind, wird das Dichtungselement zusammengedrückt, so dass es eine dichtende Anlage schafft. Zudem dient das Dichtungselement aufgrund seiner elastischen Verformbarkeit als Federelement, gegen dessen Federkraft die Hakenaufnahmen in die Hakenelemente eingehängt werden müssen.

An die Frontwand des Abdeckungsgehäuses kann ein im Winkel hierzu stehendes Deckelteil angeschlossen sein. Dieses schräge Deckelteil bildet einen in Richtung des Verkleidungselements abgekanteten horizontalen Stützabschnitt. Ei ein von der Innenseite des Deckelteils in Richtung des Verkleidungselements vorstehender, vom Stützabschnitt beabstandeter Steg definiert eine in Richtung des Verkleidungselements offene horizontale Dichtungsaufnahme. In die horizontale Dichtungsaufnahme kann wiederum ein in Richtung des Verkleidungselements zumindest teilweise hervorstehendes Dichtungselement eingelegt werden. Wenn das Abdeckungsgehäuse mit den Hakenaufnahmen in die Hakenelemente eingehängt wird, kommt der überstehende Teil des in der horizontalen Dichtungsaufnahme eingelegten Dichtungselements in gleicher Weise wie ein in der vertikalen Dichtungsaufnahme eingelegtes Dichtungselement in Kontakt mit dem Verkleidungselement.

Eine besonders gute Abdichtung kann dadurch erreicht werden, dass an den Seitenteilen und dem Stützabschnitt des Abdeckungsgehäuses eine umlaufende Dichtungsaufnahme zur Aufnahme eines in Richtung des Verkleidungselements zumindest teilweise hervorstehenden Dichtungselements angeordnet ist. Somit kann ein langgestrecktes, einteiliges Dichtungselement zum Einsatz kommen.

Das Abdeckungsgehäuse kann als Stanz-Biegeteil aus Metall, beispielsweise V2A Stahl oder aus einem Kunststoff gefertigt sein.

Die Erfindung wird nachfolgend anhand eines in den Zeichnungen dargestellten Ausführungsbeispiels näher erläutert. Es zeigen:
- Figur 1: in schematischer und geschnittener Seitenansicht eine Abdeckung, bei der das Abdeckungsgehäuse im vom Halter getrennten Zustand dargestellt ist;
- Figur 2: in schematischer Schnittansicht entlang der Schnittlinie II-II in Figur 1 die Abdeckung gemäß der Figur 1;
- Figur 3: in schematischer und geschnittener Seitenansicht die Abdeckung gemäß den Figuren 1 und 2, wobei das Abdeckungsgehäuse mit dem Halter in Eingriff steht;
- Figur 4: in schematischer Schnittansicht entlang der Schnittlinie IV-IV in Figur 3 die Abdeckung gemäß der Figur 3; und
- Figur 5: in vergrößerter Darstellung den in der Figur 1 im gestrichelten Kreis V dargestellten Bereich eines Hakenelements.

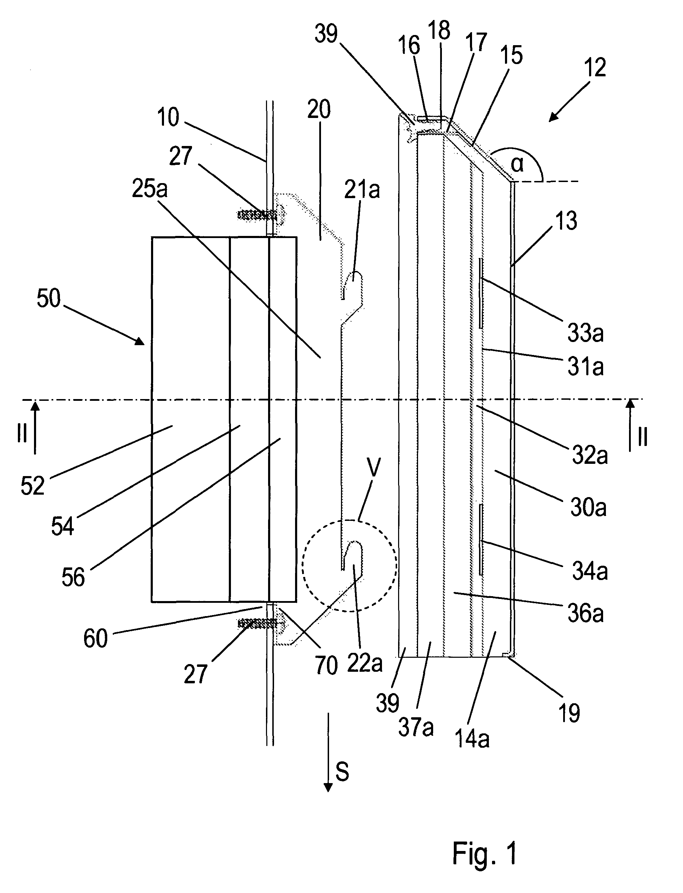

Die Figur 1 zeigt in schematischer und geschnittener Seitenansicht eine Abdeckung für eine an der Außenseite eines Verkleidungselements 10 eines Schaltschrankes angeordnete Klimatisierungseinrichtung 50. Im dargestellten Beispiel ist das Verkleidungselements 10 eine Seitenwand eines Schaltschrankes.

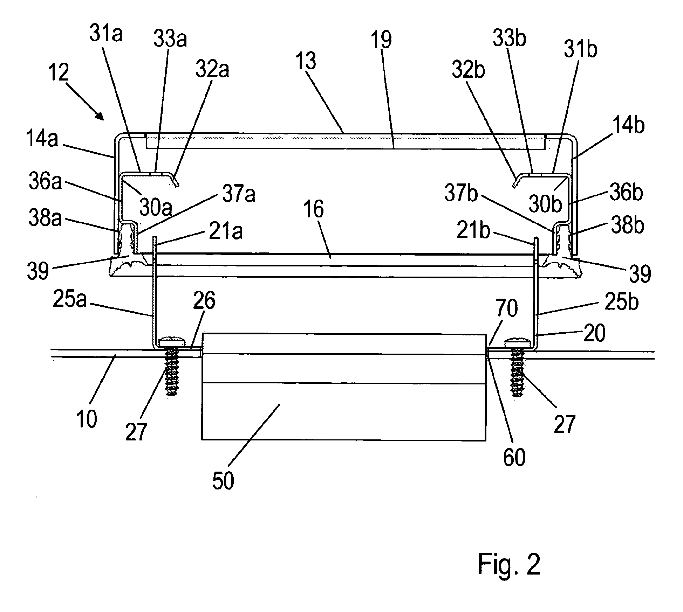

Die Figur 2 zeigt in schematischer Schnittansicht entlang der Schnittlinie II-II in Figur 1 die Abdeckung gemäß der Figur 1.

Die Klimatisierungseinrichtung 50 ist in den Figuren im Wesentlichen als eine stark vereinfachte "Black Box" dargestellt. Die dargestellte Klimatisierungseinrichtung 50 ist als Lüfter mit einer Ventilatorbaugruppe ausgebildet, der kühle Umgebungsluft in den Schaltschrankinnenraum transportiert.

Alternativ kann die Klimatisierungseinrichtung auch als Gebläse mit einer Ventilatorbaugruppe ausgebildet sein, das erwärmte Luft aus dem Schaltschrankinnenraum nach Außen transportiert. Zudem kann die Klimatisierungseinrichtung auch ohne eine Ventilatorbaugruppe realisiert sein.

Die in den Figuren gezeigte Klimatisierungseinrichtung 50 ist in einem Durchbruch 60 in dem Verkleidungselement 10 eingesetzt. Im Schaltschrankinnenraum weist die Klimatisierungseinrichtung 50 ein Ventilatorgehäuse 52 auf, welches die nicht gezeigte Ventilatorbaugruppe aufweist. Von Außen ist eine Filtermatte 54 an dem Ventilatorgehäuse 52 angelegt. Außenseitig wird die Filtermatte 54 durch ein aufgesetztes Lamellengitter 56 gehalten.

Die Abdeckung weist ein Abdeckungsgehäuse 12 mit einer Frontwand 13 auf. Wie anhand der Figur 2 deutlich wird, ist an die Frontwand 13 ein linkes Seitenteil 14a und ein rechtes Seitenteil 14b angeschlossen. Die Seitenteile 14a und 14b halten die Frontwand 13 beabstandet zu dem Verkleidungselement 10. Das Abdeckungsgehäuse 12 ist als Stanz-Biegeteil aus V2A Stahlblech gefertigt. An dem Verkleidungselement 10 ist eine Halterung 20 für das Abdeckungsgehäuse 12 angebracht.

In den Figuren 1 und 2 ist das Abdeckungsgehäuse 12 im vom Halter 20 getrennten Zustand dargestellt.

Die Halterung 20 ist als ein U-förmiger Träger ausgebildet und weist zwei zueinander beabstandete, von dem Verkleidungselement 10 in Richtung des Abdeckungsgehäuses 12 vorstehende, sich vertikal erstreckende Schenkel, den linken Schenkel 25a und den rechten Schenkel 25b, auf. Der linke Schenkel 25a weist zwei übereinander angeordnete vertikale Hakenelemente 21 a und 22a auf. Auch der rechte Schenkel weist ein unteres und ein oberes Hakenelement auf, von denen in der Figur 2 nur das obere Hakenelement 21 b gezeigt ist.

Die Schenkel 25a und 25b sind als flache Stanzformteile aus Stahlblech ausgebildet. Die Hakenelemente 21 a, 21 b und 22a sind einstückig mit den Schenkeln 25a und 25b als Verlängerung derselben ausgebildet.

Die zwei Schenkel 25a und 25b des U-förmigen Trägers sind durch einen Verbindungsabschnitt 26 miteinander verbunden. Die Schenkeln 25a und 25b sind einstückig mit dem Verbindungsabschnitt 26 ausgebildet. Zwischen den beiden Schenkeln 25a und 25b ist der Durchbruch 60 in dem Verkleidungselement 10 angebracht. In dem Verbindungsabschnitt 26 zwischen den beiden Schenkeln 25a und 25b ist ebenfalls ein Durchbruch 70 ausgebildet, der mit dem Durchbruch 60 in dem Verkleidungselement 10 fluchtet. In die fluchtenden Durchbrüchen 60 und 70 ist die Klimatisierungseinrichtung 50 eingesetzt. Der Verbindungsabschnitt 26 umgibt die Klimatisierungseinrichtung 50 rahmenförmig an der Außenseite des Verkleidungselements 10. Im Rahmenbereich des Verbindungsabschnitts 26 sind Löcher zur Durchführung von Befestigungsschrauben 27 angebracht, welche wiederum in im Verkleidungselement 10 angebrachte Schraubaufnahmen eingeführt sind.

In die vertikalen Hakenelemente 21 a, 21 b und 22a lässt sich das Abdeckungsgehäuse 12 mit Hakenaufnahmen 33a, 33b und 34a, die als vertikale Aufnahmeschlitze ausgebildet sind, in Schwerkraftrichtung gemäß dem Pfeil S einhängen. Die Hakenaufnahmen 33a, 33b und 34a sind in Profilabschnitten 31 a und 31 b von sich entlang der Seitenteile 14a und 14b des Abdeckungsgehäuses 12 erstreckenden Aufnahmeprofilen 30a und 30b ausgebildet. Die Profilabschnitte 31 a und 31 b sind quer zur Vorstehrichtung der Hakenelemente 21a, 21 b; 22a angeordnet. Der linke Profilabschnitt 31 a weist zwei übereinander angeordnete vertikale Hakenaufnahmen 33a und 34a auf. Auch der rechte Profilabschnitt 31 b weist eine untere und eine obere Hakenaufnahme auf, von denen in der Figur 2 nur die obere Hakenaufnahme 33b gezeigt ist.

Die Aufnahmeprofile 30a und 30b weisen Anlagebereiche 36a und 36b auf, die an den die Hakenaufnahmen 33a, 33b und 34a tragende Profilabschnitte 31 a und 31 b angrenzen und parallel zu den zugeordneten Seitenteilen 14a bzw. 14b des Abdeckungsgehäuses 12 abgekantet sind.

Die linken und rechten Aufnahmeprofilen 30a und 30b sind mit ihren Anlagebereichen 36a und 36b an den zugeordneten linken und rechten Seitenteilen 14a bzw. 14b angeschweißt.

Anhand der Figur 2 wird deutlich, dass die die Hakenaufnahmen 33a und 33b tragenden Profilabschnitte 31 a bzw. 31 b an ihren freien Ende jeweils in einem Winkel in Richtung des Verkleidungselements 10 abgekantet sind. Die Abkantungen bilden jeweils eine Einfädelhilfe 32a und 32b für die Hakenelemente.

Die Aufnahmeprofile 30a und 30b weisen jeweils einen an den Anlagebereich 36a bzw. 36b angrenzenden, L-förmig abgekantenen Profilabschnitt 37a und 37b auf. Der linke Profilabschnitt 37a bildet eine in Richtung des Verkleidungselement 10 offene, sich entlang des linken Seitenteils 14a des Abdeckungsgehäuses 12 erstreckende vertikale linke Dichtungsaufnahme 38a. Der rechte Profilabschnitt 37b bildet ebenfalls eine in Richtung des Verkleidungselements 10 offene, sich entlang des rechten Seitenteils 14b des Abdeckungsgehäuses 12 erstreckende vertikale rechte Dichtungsaufnahme 38a. In die vertikalen Dichtungsaufnahmen 38a und 38b ist ein in Richtung des Verkleidungselements 10 teilweise hervorstehendes Dichtungselement 39 eingelegt.

Wie anhand der Figur 1 deutlich wird, ist an die Frontwand 13 des Abdeckungsgehäuses 12 ein im Winkel α hierzu stehendes schräges Deckelteil 15 angeschlossen, das einen in Richtung des Verkleidungselements 10 abgekanteten horizontalen Stützabschnitt 16 bildet. Von der Innenseite des schrägen Deckelteils 15 ist ein in Richtung des Verkleidungselements 10 vorstehender, vom Stützabschnitt beabstandeter Steg 17 angeordnet. Der Steg 17 bildet zusammen mit dem abgekanteten horizontalen Stützabschnitt 16 eine in Richtung des Verkleidungselements 10 offene horizontale Dichtungsaufnahme 18. In die horizontale Dichtungsaufnahme 18 ist ein in Richtung des Verkleidungselements 10 teilweise hervorstehendes Dichtungselement 39 eingelegt.

An den Seitenteilen 14a und 14b und dem horizontalen Stützabschnitt 16 des Abdeckungsgehäuses 12 ist eine umlaufende Dichtungsaufnahme ausgebildet, in der das Dichtungselement 39 als langgestrecktes, einteiliges, elastisches Formteil eingelegt ist.

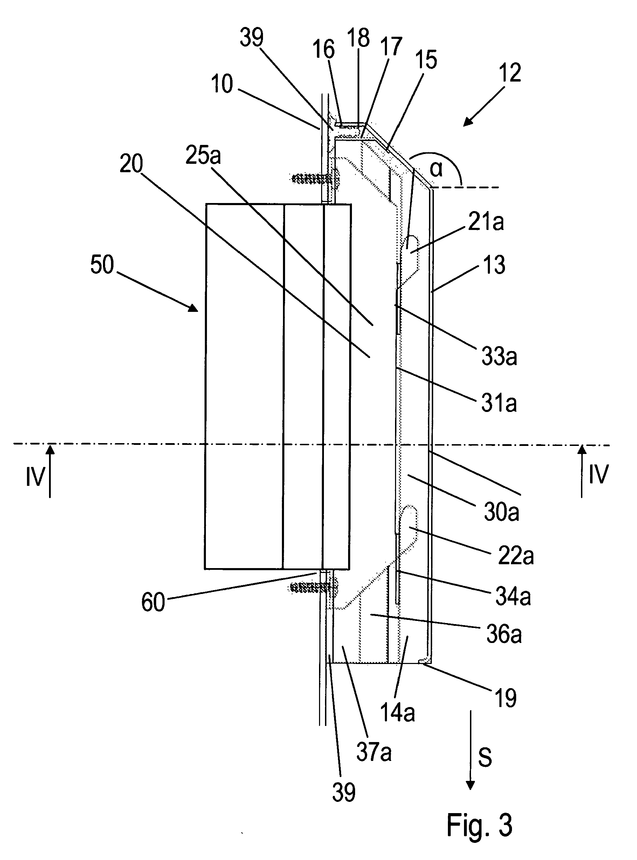

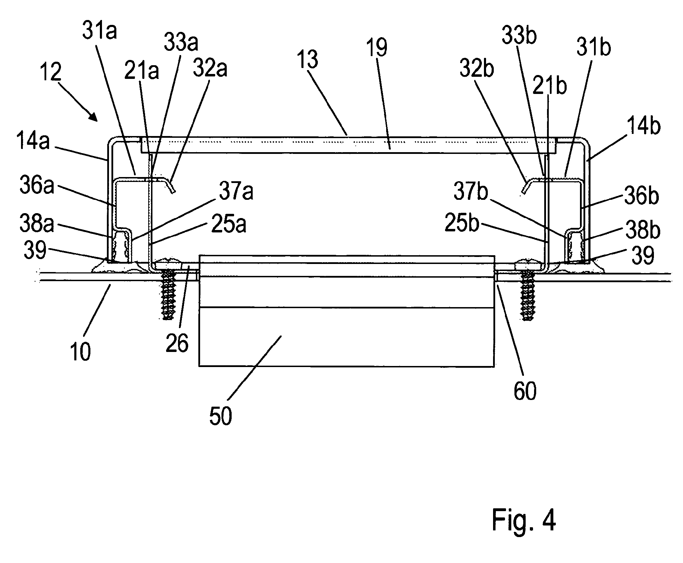

Die Figur 3 zeigt in schematischer und geschnittener Seitenansicht die Abdeckung gemäß den Figuren 1 und 2, wobei das Abdeckungsgehäuse 12 mit dem Halter 20 in Eingriff steht. Die Figur 4 zeigt in schematischer Schnittansicht entlang der Schnittlinie IV-IV in Figur 3 die Abdeckung gemäß der Figur 3.

In den Darstellungen der Figuren 3 und 4 ist in die vertikalen Hakenelemente 21 a und 22a des Halters 20 das Abdeckungsgehäuse 12 mit Hakenaufnahmen 33a und 34a, die als vertikale Aufnahmeschlitze ausgebildet sind, in Schwerkraftrichtung gemäß dem Pfeil S eingehängt. Das in der umlaufenden Dichtungsaufnahme umlaufende, in Richtung des Verkleidungselements 10 teilweise hervorstehende Dichtungselement 39 ist zwischen dem Abdeckungsgehäuse 12 und dem Verkleidungs-element 10 eingepresst und verformt.

Beim Einhängen der Hakenaufnahmen 33a und 34a des Abdeckungsgehäuses 12 in die Hakenelemente 21 a und 22a des Halters 20, kommt der überstehende Teil des Dichtungselements 39 in Kontakt mit dem Verkleidungselement 10. Wenn die Hakenaufnahmen 33a und 34a vollständig in den Hakenelementen 21 a und 22a eingehängt sind, wird das Dichtungselement 39 zusammengedrückt, so dass es eine dichtende Anlage zum Verkleidungselement 10 schafft. Zudem dient das Dichtungselement 39 aufgrund seiner elastischen Verformbarkeit als Federelement, gegen dessen Federkraft die Hakenaufnahmen 33a und 34a in die Hakenelemente eingehängt werden müssen.

Zur Demontage des Abdeckungsgehäuses 12 müssend die Hakenaufnahmen 33a und 34a des Abdeckungsgehäuses 12 mit den Hakenelemente 21 a und 22a des Halters 20 außer Eingriff gebracht werden. Dabei muss die durch die Federkraft des Dichtungselements 39 hervorgerufene Anpresskraft überwunden werden. Dazu kann beispielsweise mit dem Handballen an den unteren Randbereich des Abdeckungsgehäuses 12 eine gegen die Schwerkraftrichtung S gerichtete Kraft aufgebracht werden. Der untere Randbereich des Abdeckungsgehäuses 12 ist an der Frontwand 13 nach innen abgekantet und bildet einen Kantenschutz 19 für den Handballen.

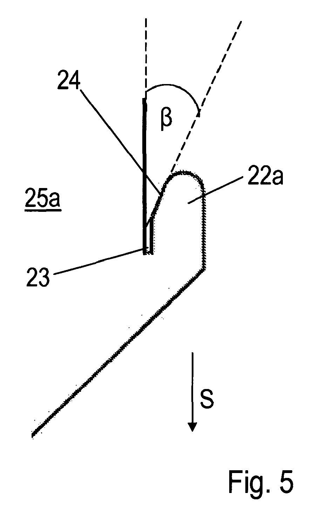

Die Figur 5 zeigt in vergrößerter Darstellung den in der Figur 1 im gestrichelten Kreis V dargestellten Bereich des Hakenelements 22a. Das Hakenelement 22a weist einen vertikalen, nach oben offenen Aufnahmespalt 23 für die Hakenaufnahme 33a auf. Das Hakenelement 22a verläuft von der Hakenspitze zum Aufnahmespalt 23 in einer im Winkel β geneigten Auflaufschräge 24. Wenn die Hakenaufnahme 33a bei der Montage in dem Bereich der Auflaufschräge 24 gelangt, wird es bei einer Bewegung in Schwerkraftrichtung S an der Auflaufschräge entlang gleitend in Richtung des Aufnahmespalts 23 gedrängt. Dadurch wird auch das Abdeckungsgehäuse 12 in Richtung des Verkleidungselements 10 gedrängt, so dass der überstehende Teil des Dichtungselements 39 in dichtenden Kontakt mit dem Verkleidungselement 10 kommt.

## Patentansprüche

1. Abdeckung für mindestens eine an einem Verkleidungselement (10) eines Schaltschrankes angeordnete Klimatisierungseinrichtung (50), mit einem Abdeckungsgehäuse (12), das eine Frontwand (13) und daran angeschlossene Seitenteile (14a; 14b) aufweist, wobei die Seitenteile (14a; 14b) die Frontwand (13) beabstandet zu dem Verkleidungselement (10) halten und an dem Verkleidungselement (10) mindestens eine Halterung (20) für das Abdeckungsgehäuse (12) angebracht ist, und wobei die Halterung (20) vertikale Hakenelemente (21 a, 21 b; 22a) aufweist, in die das Abdeckungsgehäuse (12) mit Hakenaufnahmen (33a, 33b; 34a) in Schwerkraftrichtung (S) einhängbar ist,
**dadurch gekennzeichnet, dass** die an dem Abdeckungsgehäuse (12) vorgesehenen Hakenaufnahmen (33a, 33b; 34a) in an den Seitenteilen (14a; 14b) angeschlossene, sich entlang der Seitenteile (14a; 14b) des Abdeckungsgehäuses (12) erstreckende Aufnahmeprofile (30a, 30b) ausgebildet sind, die jeweils zumindest einen quer zur Vorstehrichtung der Hakenelemente (21a, 21b; 22a) angeordneten, die Hakenaufnahmen (33a, 33b; 34a) tragenden Profilabschnitt (31a, 31b) aufweisen,
dass der die Hakenaufnahmen (33a, 33b; 34a) tragende Profilabschnitt (31a, 31b) an seinem freien Ende in einem Winkel in Richtung des Verkleidungselements (10) zur Bildung einer Einfädelhilfe (32a, 32b) für die Hakenelemente (21a, 21b; 22a) abgekantet ist, und
die Aufnahmeprofile (30a, 30b) jeweils einen an den die Hakenaufnahmen (33a, 33b; 34a) tragenden Profilabschnitt (31a, 31b) angrenzenden, parallel zu dem zugeordneten Seitenteil (14a; 14b) des Abdeckungsgehäuses (12) abgekanteten Anlagebereich (36a, 36b) aufweisen, der an der Innenseite des zugeordneten Seitenteils (14a; 14b) angeschlossen ist.

2. Abdeckung nach Anspruch 1,
**dadurch gekennzeichnet,**
**dass** die Halterung (20) zumindest zwei zueinander beabstandete, von dem Verkleidungselement (10) in Richtung des Abdeckungsgehäuses (12) vorstehende Schenkel (25a, 25b) aufweist, wobei jeder Schenkel (25a, 25b) mindestens ein vertikales, von den Schenkeln (25a, 25b) in Richtung des Abdeckungsgehäuses (12) vorstehendes Hakenelement (21a, 21b; 22a) aufweist.

3. Abdeckung nach Anspruch 2,
**dadurch gekennzeichnet,**
**dass** zwischen den beiden Schenkeln (25a, 25b) ein Durchbruch (60) in dem Verkleidungselement (10) ausgebildet ist, in welchem die Klimatisierungseinrichtung (50) anordenbar ist.

4. Abdeckung nach Anspruch 2 oder 3,
**dadurch gekennzeichnet,**
**dass** die Halterung (20) einen U-förmigen Träger mit zwei Schenkeln (25a, 25b) aufweist, die durch einen Verbindungsabschnitt (26) miteinander verbunden sind.

5. Abdeckung nach Anspruch 4,
**dadurch gekennzeichnet,**
**dass** im Verbindungsabschnitt (26) zwischen den beiden Schenkeln (25a, 25b) ein Durchbruch (70) ausgebildet ist, der mit dem Durchbruch (60) in dem Verkleidungselement (10) im Wesentlichen fluchtet und in welchem die Klimatisierungseinrichtung (50) anordenbar ist.

6. Abdeckung nach Anspruch 1,
**dadurch gekennzeichnet,**
**dass** die Aufnahmeprofile (30a, 30b) einen an den Anlagebereich (36a, 36b) angrenzenden, L-förmig abgekanteten Profilabschnitt (37a, 37b) aufweisen, der eine in Richtung des Verkleidungselement (10) offene, sich entlang der Seitenteile (14a; 14b) des Abdeckungsgehäuses (12) erstreckende vertikale Dichtungsaufnahme (38a, 38b) bildet, in welche ein in Richtung des Verkleidungselements 10) zumindest teilweise hervorstehendes Dichtungselement 39) einlegbar ist.

7. Abdeckung nach einem der Ansprüche 1 bis 6,
**dadurch gekennzeichnet,**
**dass** an die Frontwand (13) des Abdeckungsgehäuses (12) ein im Winkel (α) hierzu stehendes Deckelteil (15) angeschlossen ist, das einen in Richtung des Verkleidungselements (10) abgekanteten horizontalen Stützabschnitt (16) bildet, wobei ein von der Innenseite des Deckelteils (15) in Richtung des Verkleidungselements (10) vorstehender, vom Stützabschnitt beabstandeter Steg (17) angeordnet ist, der eine in Richtung des Verkleidungselements (10) offene horizontale Dichtungsaufnahme (18) definiert, in welche ein in Richtung des Verkleidungselements (10) zumindest teilweise hervorstehendes Dichtungselement (39) einlegbar ist.

## Claims

1. A cover for at least one air-conditioning device (50) arranged on a cladding element (10) of a switchgear cabinet, comprising a cover housing (12) having a front wall (13) and side parts (14a; 14b) connected thereto, the side parts (14a; 14b) keeping the front wall (13) at a distance from the cladding element (10) and at least one holder (20) for the cover housing (12) being fitted to the cladding element (10) and wherein the holder (20) comprises vertical hook elements (21a, 21b; 22a) into which the cover housing (12) can be suspended by hook receptacles (33a, 33b; 34a) in the direction (S) of gravity,
**characterized in that** the hook receptacles (33a, 33b; 34a) provided at the cover housing (12) are formed in receiving profiles (30a, 30b) connected to the side parts (14a; 14b) and extending along the side parts (14a; 14b) of the cover housing (12) and respectively comprising at least one profiled section (31 a, 31 b) which carries the hook receptacles (33a, 33b; 34a) and is arranged transversely to the direction of protrusion of the hook elements (21 a, 21 b; 22a),
that the profiled section (31a, 31b) carrying the hook receptacles (33a, 33b; 34a) is bent at a free end thereof at an angle towards the cladding element (10) for forming a mounting assist (32a, 32b) for the hook elements (21a, 21,; 22a); and
the receiving profiles (30a, 30b) respectively comprise an abutment section (36a, 36b) which is bent parallel to the associated side part (14a, 14b) of the cover housing (12) and is adjacent to the profiled section (31a, 31b) carrying the hook receptacles (33a, 33b; 34a), the abutment section being connected to the inner surface of the associated side part (14a; 14b).

2. The cover of claim 1, **characterized in that** the holder (20) comprises at least two legs (25a, 25b) which are spaced apart from another and protrude from the cladding element (10) towards the cover housing (12), wherein each leg (52a, 25b) comprises at least one vertical hook element (21a, 21b: 22a) protruding from the legs (25a, 25b) towards the cover housing (12).

3. The cover of claim 2, wherein an opening (60) in the cladding element (10) is formed between the two legs (25a, 25b) in which the air-conditioning device (50) can be arranged.

4. The cover of claim 2, **characterized in that** the holder (20) comprises a U-shaped support having two legs (25a, 25b) which are interconnected by a connecting section (26).

5. The cover of claim 4, **characterized in that** an opening (70) is formed in the connecting section (26) between the two legs (25a, 25b) which is substantially aligned with the opening (60) of the cladding element (10) and in which the air-conditioning device (50) can be arranged.

6. The cover of claim 1, **characterized in that** the receiving profiles (30a, 30b) comprise a profiled section (37a, 37b) which is bent to L-shape and is adjacent to the abutment section (36a, 36b) and which forms a vertical seal receiver (38a, 38b)extending along the side parts (14a, 14b) of the cover housing (12) and open towards the cladding element (10), into which a sealing element (39) may be inserted which at least partly protrudes towards the cladding element (10).

7. The cover of any of claims 1 to 6, **characterized in that** a lid element (15) is connected at an angle (α) to the front wall (13) of the cover housing (12), which forms a horizontal supporting section (16) bent towards the cladding element (10), wherein a bar (17) is provided which protrudes from the inner surface of the lid element (15) towards the cladding element (10) and is spaced apart from the supporting section and which defines a horizontal seal receiver (18) open towards the cladding element (10) into which a sealing element (39) may be inserted which at least partly protrudes towards the cladding element (10).

## Revendications

1. Cache pour au moins un dispositif de climatisation (50) monté sur un élément de parement (10) d'une armoire de commande, ledit cache comportant un carter (12), muni d'une paroi avant (13) et d'éléments latéraux (14a ; 14b) attachés à celle-ci, les éléments latéraux (14a ; 14b) maintenant la paroi avant (13) à une distance de l'élément de parement (10), et au moins une fixation (20) pour le carter (12) étant attachée à l'élément de parement (10), et ladite fixation (20) comportant des crochets (21a, 21b ; 22a) dans lesquels le carter (12) peut être accroché via des logements pour crochets (33a, 33b ; 34a) dans le sens de la pesanteur (S),
**caractérisé**
**en ce que** les logements pour crochets (33a, 33b ; 34a), prévus sur le carter (12), sont réalisés dans des profilés de fixation (30a, 30b), qui sont attachés aux éléments latéraux (14a ; 14b) et s'étendent le long des éléments latéraux (14a ; 14b) du carter (12) et qui comportent chacun au moins une partie de profilé (31a, 31b) disposée transversalement au sens de proéminence des crochets (21a, 21b ; 22a) et portant les logements pour crochets (33a ; 33b ; 34a),
**en ce que** la partie de profilé (31a, 31b) portant les logements pour crochets (33a ; 33b ; 34a) est pliée au niveau de son extrémité libre en un angle dirigé vers l'élément de parement (10) pour former une aide à l'enfichage (32a, 32b) pour les crochets (21a, 21b ; 22a), et
les profilés de fixation (30a, 30b) comportent chacun une zone d'appui (36a, 36b), qui est adjacente à la partie de profilé (31a, 31b) portant les logements pour crochets (33a ; 33b ; 34a) et est parallèle à l'élément latéral (14a ; 14b) correspondant du carter (12) et qui est attachée à la face intérieure de l'élément latéral (14a ; 14b) correspondant.

2. Cache selon la revendication 1, **caractérisé en ce que** la fixation (20) comporte au moins deux branches (25a, 25b) écartées l'une de l'autre et en saillie sur l'élément de parement (10) vers le carter (12), chaque branche (25a, 25b) comportant au moins un crochet (21a, 21b ; 22a) vertical, en saillie sur les branches (25a, 25b) vers le carter (12).

3. Cache selon la revendication 2, **caractérisé en ce que** dans l'élément de parement (10), entre les deux branches (25a, 25b), est réalisée une percée (60), dans laquelle peut être agencé le dispositif de climatisation (50).

4. Cache selon la revendication 2 ou 3, **caractérisé en ce que** la fixation (20) comporte un support en forme de U avec deux branches (25a, 25b) qui sont reliées l'une à l'autre par une partie de liaison (26).

5. Cache selon la revendication 4, **caractérisé en ce que** dans la partie de liaison (26), entre les deux branches (25a, 25b), est réalisée une percée (70), qui est sensiblement alignée à la percée (60) dans l'élément de parement (10) et dans laquelle peut être agencé le dispositif de climatisation (50).

6. Cache selon la revendication 1, **caractérisé en ce que** les profilés de fixation (30a, 30b) comportent une partie de profilé (37a, 37b) qui est pliée en L et est adjacente à la zone d'appui (36a, 36b) et qui forme un logement d'étanchéité (38a, 38b) vertical, qui est ouvert vers l'élément de parement (10) et s'étend le long des éléments latéraux (14a ; 14b) du carter (12) et dans lequel peut être inséré un élément d'étanchéité (39) au moins partiellement en saillie vers l'élément de parement (10).

7. Cache selon l'une quelconque des revendications 1 à 6, **caractérisé en ce qu'**à la paroi avant (13) du carter (12) est attaché un couvercle (15) qui forme un angle (α) avec celle-ci et qui forme une partie d'appui (16) horizontale pliée vers l'élément de parement (10), une ailette (17), située à distance de la partie d'appui (16) et en saillie sur la face intérieure du couvercle (15) vers l'élément de parement (10), étant prévue et définissant un logement d'étanchéité (18) horizontal ouvert vers l'élément de parement (10), dans lequel peut être inséré un élément d'étanchéité (39) au moins partiellement en saillie vers l'élément de parement (10).
